Europäisches Patentamt

European Patent Office

Office européen des brevets

(19)

(11) Publication number: **0 119 729**
**B1**

# EUROPEAN PATENT SPECIFICATION

(12)

(45) Date of publication of patent specification: 27.07.88

(51) Int. Cl.⁴: **H 01 L 29/60, G 11 C 17/00**

(21) Application number: **84300920.0**

(22) Date of filing: **14.02.84**

(54) Semiconductor memory device.

(30) Priority: **14.02.83 JP 22271/83**

(43) Date of publication of application:
**26.09.84 Bulletin 84/39**

(45) Publication of the grant of the patent:
**27.07.88 Bulletin 88/30**

(84) Designated Contracting States:
**DE FR GB**

(56) References cited:
**US-A-4 192 014**
**US-A-4 272 830**
**US-A-4 282 646**
**US-A-4 294 001**

**IBM TECHNICAL DISCLOSURE BULLETIN, vol.
23, no. 10, March 1981, page 4461, Armonk,
New York, US
IDEM**

(73) Proprietor: **FUJITSU LIMITED
1015, Kamikodanaka Nakahara-ku
Kawasaki-shi Kanagawa 211 (JP)**

(72) Inventor: **Nagasawa, Masanori c/o FUJITSU
LIMITED
Patent Department 1015 Kamikodanaka
Nakahara-ku Kawasaki-shi Kanagawa 211 (JP)**
Inventor: **Suzuki, Yasuo c/o FUJITSU LIMITED
Patent Department 1015 Kamikodanaka
Nakahara-ku Kawasaki-shi Kanagawa 211 (JP)**
Inventor: **Hirao, Hiroshi c/o FUJITSU LIMITED
Patent Department 1015 Kamikodanaka
Nakahara-ku Kawasaki-shi Kanagawa 211 (JP)**

(74) Representative: **Sunderland, James Harry et al
HASELTINE LAKE & CO Hazlitt House 28
Southampton Buildings Chancery Lane
London WC2A 1AT (GB)**

Courier Press, Leamington Spa, England.

### Description

This invention relates to a semiconductor memory device, and is more particularly concerned with a multi-level memory device.

A read-only memory (ROM) is a device that is used for storing fixed information. The information is stored in a memory cell matrix. The basic storage elements of a mask ROM are metal insulator semiconductor (MIS) transistors, metal oxide semiconductor (MOS) transistors being generally used. Current carried by each matrix cell element (transistor) represents stored information. The stored information is written into the ROM during manufacture.

Usually, a substrate carrying a matrix arrangement of transistors is prepared, and then each of the transistors is wired according to the information to be stored. This wiring stage is usually executed relatively late in the total ROM fabrication process. This enables manufacturers to stock "half-fabricated" mask ROMs, awaiting the information writing process. Thus, when mask ROMs required to hold new or different information are ordered by a customer, a writing mask corresponding to the new or different information is prepared and "half-fabricated" ROMs from stock are completed by executing the writing process. From the point of view of the customer this provides a reduced fabrication time, and delivery time is shortened.

There is a strong demand for a capability to increase the amount of information stored per unit area of a chip. This is leading to the development of multi-level logic circuits which, instead of binary arithmetic, use base 3 or base 4 arithmetic, for example. In a multi-level memory device, cell transistor current has to be capable of taking a number of different values corresponding to the different possible values of the information digits. Cell transistor current can be altered by altering the channel width of the cell transistors.

Information concerning multi-level semiconductor memories is given in, for instance, Feb. 24/1981 Electronics, page 100, by J. G. Posa and Jun. 30/1982 Electronics, page 81, by J. R. Lineback.

For example, fabrication of a multi-level mask ROM starts with the formation of a field oxide layer (usually, silicon dioxide layer) on a substrate. After the field oxide layer is grown, metal insulator semiconductor (MIS) transistors and other circuit elements are created in open areas in the field oxide layer. The widths of the channels of the MIS transistors are determined at this stage. For fabricating a new ROM, for storing predetermined information in a multi-level memory device, MIS transistors having various current levels (when the ROM is in use) are formed in a memory matrix of the ROM in accordance with the values or levels of multi-level information digits to be stored. Transistor current levels are determined by the channel widths of the transistors, which widths are defined by the field oxide layers. This means that the stored information is written into the multi-level ROM at an early stage in the total ROM fabricating process; that is, at the stage of field oxide layer formation.

So, for a binary ROM, a manufacturer can stock ROM slices or substrates having many prefabricated transistors thereon, and when new ROM information is selected by a customer the manufacturer can complete ROMs starting from the slices on which the transistors are already fabricated. The manufacturer has only to wire the ROM transistors to finish the ROM.

On the other hand, when new ROM information is selected by a customer for multi-level ROMs, the manufacturer must start with the fabrication of transistors. Thus, from the customer's point of view, it takes a longer time to fabricate a multi-level ROM than a binary ROM.

IBM Technical Disclosure Bulletin, vol. 23, No. 10, March 1981, page 4461; K. Bernstein, "Four State Memory Cell for Read Only Storage", discloses a read-only memory cell providing four-state or four-level operation by digitally controlling the magnitude of the effective channel conductance of an IGFET device through the use of ion implantation of none, 1/3, 2/3 or all of the width of the channel. The technique involved may be implemented in an n-channel technology by the ion implantation of p-type impurities into the IGFET channel region to block all, 1/3, 2/3 or none of the channel width of each storage device in the memory array. Portions of the channel are implanted to raise the threshold voltage above that normally expected from the n-channel process by which the memory array is fabricated. Various additional techniques are available for controlling the threshold of portions of the channel width in addition to the use of masked ion-implanted regions, such as the use of a programmable electron beam to write a high threshold voltage in an MNOS nonvolatile IGFET.

US—A—4 282 646 discloses, in relation to a two-level ROM device having an array of IGFETs, a means of raising the threshold of selected transistors, as compared with other transistors, by selectively introducing impurities into regions of the device substrate defined by the edges of the gates of the transistors. In relation to transistors which are to have a lower threshold, only a first impurity, of opposite conductivity type to the substrate, is implanted into the relevant region. In relation to transistors which are to have a higher threshold, a second impurity, of opposite conductivity type to the first impurity and of significantly higher diffusion, is implanted. The impurities are driven in by heating.

According to the present invention there is provided a semiconductor memory device, having a plurality of multi-level memory cells with metal insulator semiconductor transistors, formed in zones defined by field insulation, each comprising source and drain regions doped with a first conductivity type, and a channel region doped with a second conductivity type, and each having the same maximum possible channel width defined by the field insulation, at least one of the said transistors also having two additional

doped regions, provided respectively on opposite sides of the channel of the transistor concerned, doped with dopant of the second conductivity type, to a higher concentration than the rest of that channel, giving the transistor concerned an effective channel width less than the maximum possible channel width therefore.

An embodiment of the present invention can provide a semiconductor multi-level memory device such that fabrication time for responding to an order from a customer can be reduced.

In an embodiment of the present invention the memory device is such that gate electrodes and source-drain regions of MIS transistors can be formed on a ROM substrate in advance of a customer's order (that is, before the information to be stored is known to the manufacturer) and the substrates then held in stock waiting for the customer's order. When the order is received, information to be stored is written into the memory matrix in accordance with the customer's wishes by the application of MIS transistors whose channel width is variable.

The present invention also provides a method of fabricating such a semiconductor multi-level memory device.

The memory storage elements of such a semiconductor multi-level memory device are composed of MIS transistors whose currents are selected to correspond to the multi-level information to be stored. This selection is effected by varying the channel width of the MIS transistors in correspondence to the information to be stored.

In a semiconductor multi-level ROM embodying the present invention, at the "half-fabricated" stage the memory matrix has only "standard" type MIS transistors. These standard type MIS transistors correspond to the highest current, and widest transistor channel width, which is usually defined by a field oxide layer. In the writing of information into the ROM, standard type MIS transistors of the "half-fabricated" ROM are selectively converted into the transistors having lower (including no) current, in correspondence to the digit level of the information to be stored.

The conversion of standard type transistors is effected reducing their channel widths. This reduction of channel width is attained by a conventional ion implantation method. Dopant having opposite conductivity to that of drain and source region of a standard type MIS transistor is selectively ion-implanted into the channel region of the transistor to form two highly doped regions in the channel region to opposite sides of the channel region, such as to reduce the effective channel width.

Reference is made, by way of example, to the accompanying drawings, in which:—

Fig. 1 shows a schematic circuitry diagram (a) and a schematic plan view (b) of a memory matrix contained in a previous NOR type binary mask ROM;

Fig. 2 shows a schematic plan view (a) of a memory cell of a previous multi-level mask ROM and schematic sectional views (b) of MOS transistors contained in the ROM;

Fig. 3 illustrates the structure of a multi-level mask ROM embodying the present invention; in Fig. 3(a) is a schematic plan view of a memory cell of the ROM and (b) gives schematic sectional views of MOS cell transistors; and

Fig. 4 to Fig. 9 illustrate a series of fabrication processes for fabricating a mask ROM as illustrated in Fig. 3, each Figure schematically showing a part of the memory matrix of the ROM, at the relevant fabrication stage, in a plan view and in sectional views taken along flagged lines designated in the plan views;

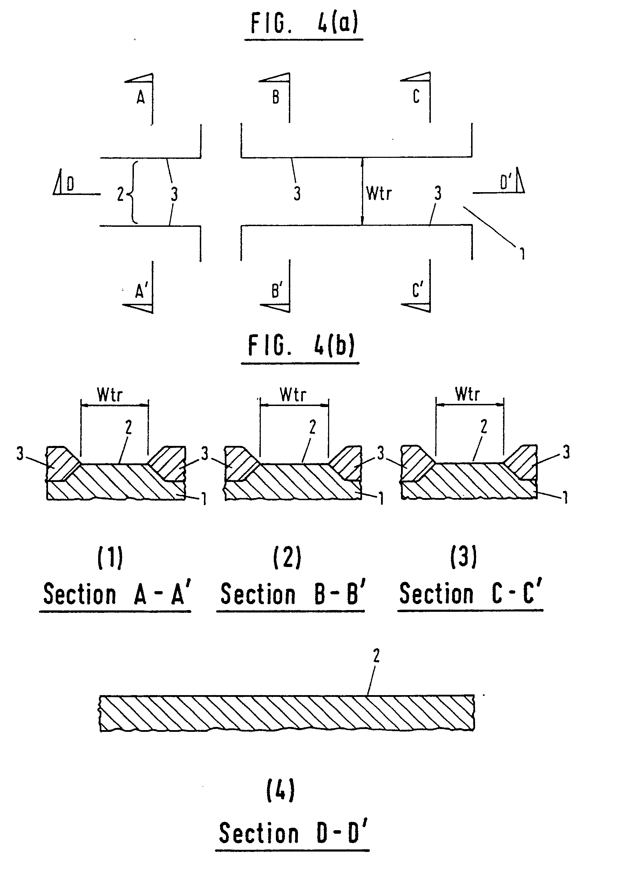

Fig. 4 shows the memory matrix part after field insulator layer formation;

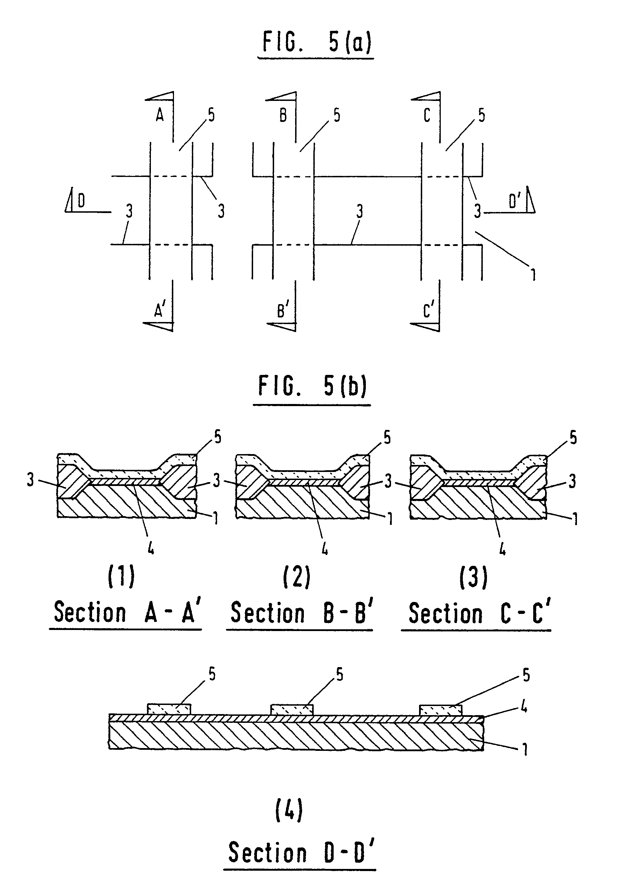

Fig. 5 shows the memory matrix part after polycrystalline silicon gate electrode formation;

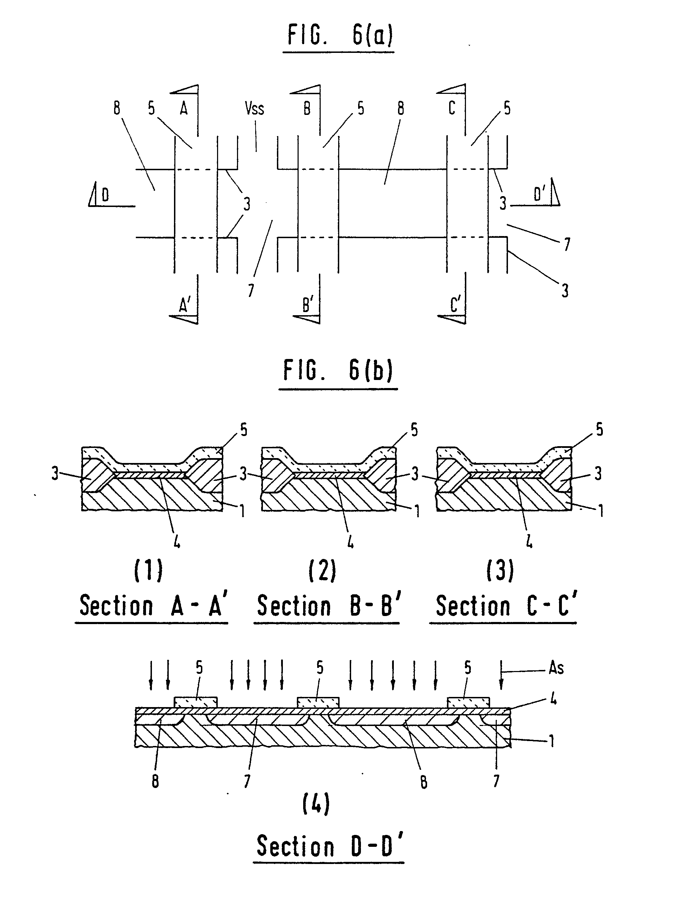

Fig. 6 shows the memory matrix part after source and drain region formation;

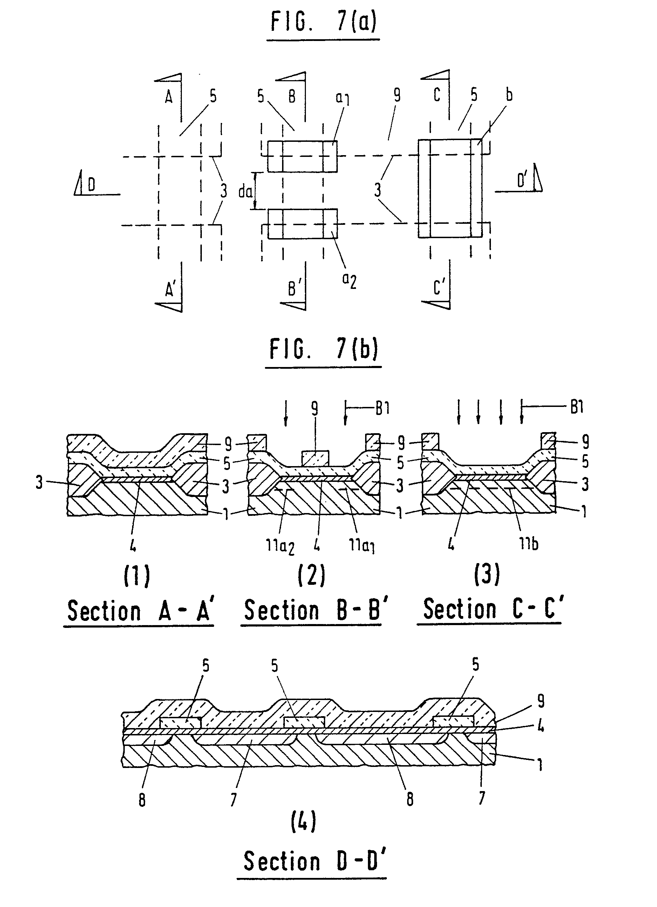

Fig. 7 shows the memory matrix part after boron dopant is implanted into the substrate at specified regions of original channel regions;

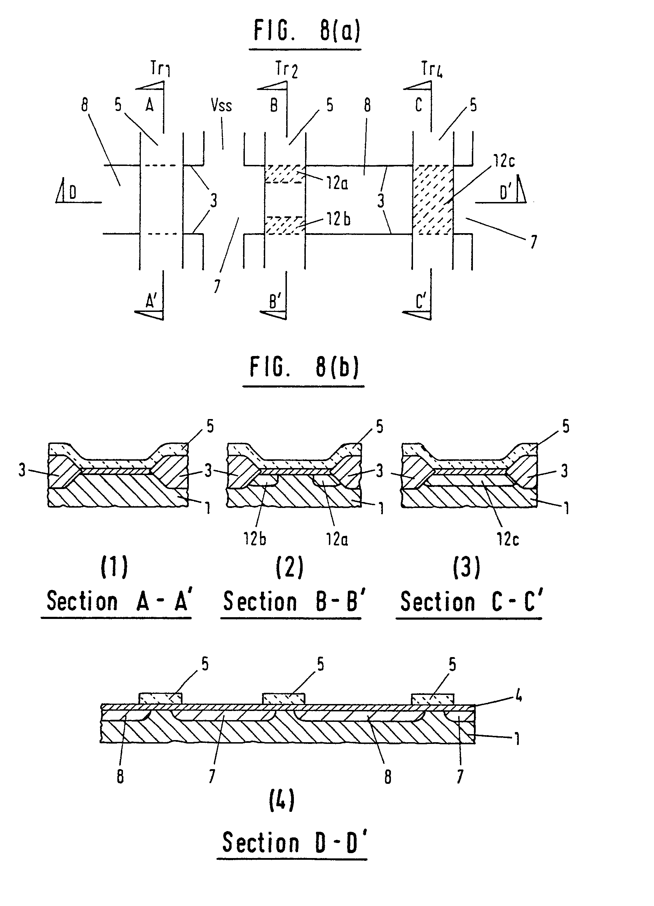

Fig. 8 shows the memory matrix part after effective channels of MIS transistors are formed by an annealing process; and

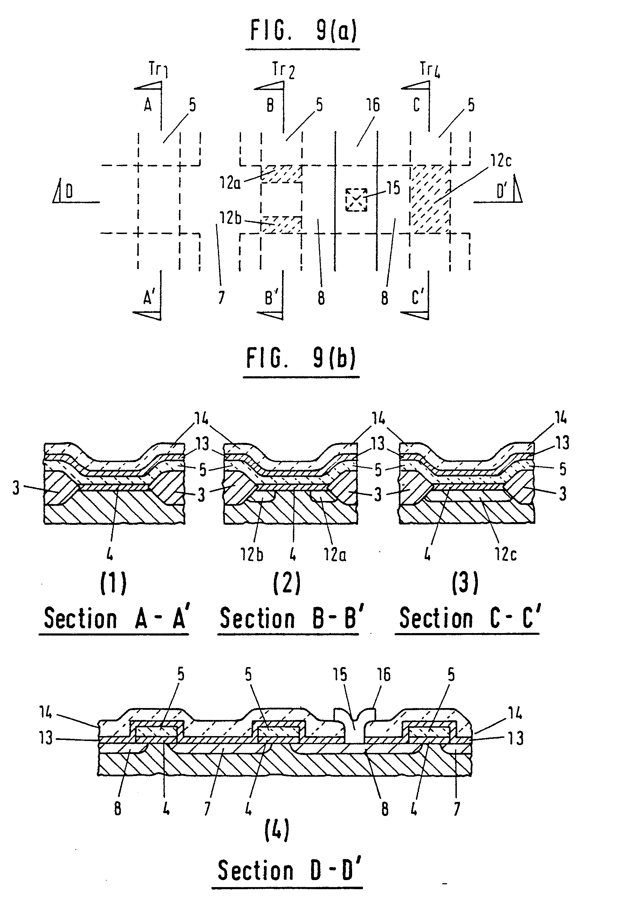

Fig. 9 shows the memory matrix part at the final fabrication stage.

The structures of previous semiconductor memories will first be briefly described.

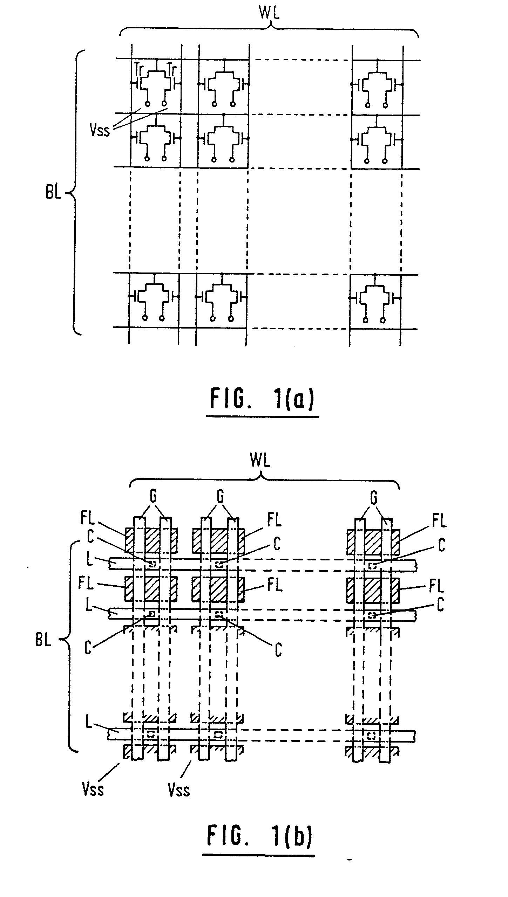

In the previous NOR type binary mask ROM of Fig. 1, Tr indicates metal insulator semiconductor (MIS) transistors, generally being metal oxide semiconductor (MOS) transistors. Vss refers to a ground line, G indicates gate electrodes, L indicates drain wiring, C indicates drain contact windows, FL indicates field oxide layers, BL indicates bit lines and WL indicates word lines.

In Fig. 1(a), at each intersection of a bit line BL and a word line WL, a MIS transistor of the memory cell matrix is formed. The writing of the storage information into a mask ROM is performed during its fabrication. The current carried by each transistor (that is each memory cell) when the device is in use corresponds to the information stored therein. Cell transistors of only one type are used, and writing of information is accomplished by selectively wiring the transistors.

The readout of information stored in a particular cell in the matrix is accomplished by sensing the current flow in the cell transistors. For instance, when an information bit stored in a cell at the intersection of an m'th word line (column) and an n'th bit line (row) is to be read out, readout voltage is applied to the m'th column and the consequent transistor current which flows is sensed through the n'th row. All the information bits stored in the ROM can be read out one by one consecutively and thus all the information stored in the ROM read out.

The gate electrodes G and drain wiring L shown in Fig. 1(b) correspond to the word lines WL and bit lines BL respectively. At each intersection of these lines an MIS transistor is formed. Connection (selective wiring) of a bit line to a cell transistor is performed by contacting the drain wiring L to the drain region of the MIS transistor through a window C.

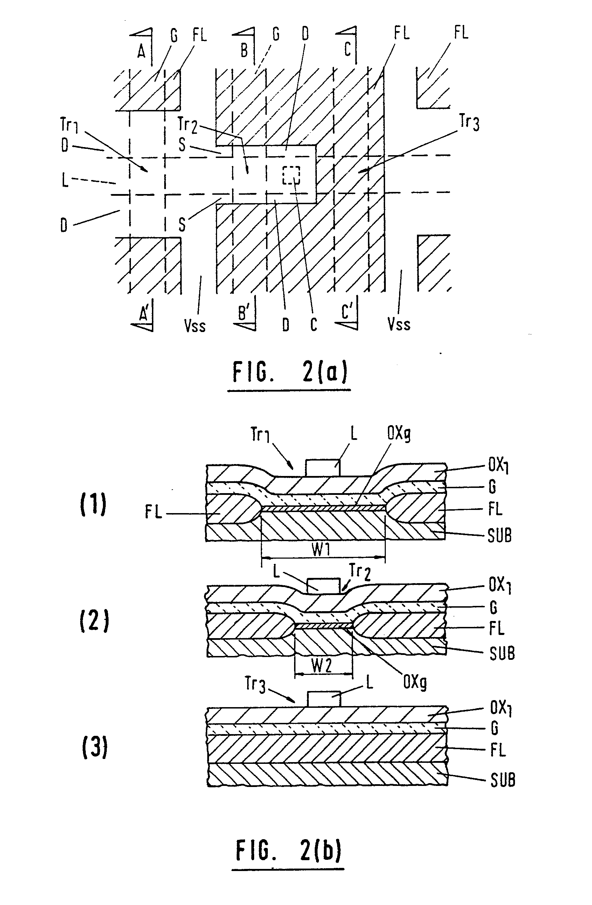

Fig. 2 illustrates the memory cell structure of a previous multi-level (three level) ROM and it will now be explained how information is written into the cell. Fig. 2(a) is a plan view of a part of the memory matrix of the ROM and Fig. 2(b) shows at (1), (2) and (3) structures of cell transistors in sections taken respectively along lines A—A', B—B' and C—C' and viewed in the directions in which the flags on those lines taper in the plan view. In Fig. 2, $Tr_1$, $Tr_2$, $Tr_3$ are cell transistors having respective different currents when in use, SUB is a silicon substrate, FL is a field oxide layer, OXg is a gate oxide layer, G indicates a gate electrode (word line), Vss indicates ground lines, S is a source region, D is a drain region, $OX_1$ is an insulating layer, C is an electrode window and L is drain wiring (bit line).

A multi-level output signal is provided by the cell of Fig. 2 by the combination of different output currents of the MIS cell transistors.

The source-drain current of an MOS transistor depends on the channel width. With narrower gate channels, channel resistance is increased and the current is lower.

So, transistor $Tr_1$ in Fig. 2, having the greatest width $W_1$ (see Fig. 2(b) (1)) carries the highest current. The transistor $Tr_2$ has a medium channel width ($W_2$—see Fig. 2(b) 2) and medium current. The transistor $Tr_3$ has no channel, so provides no current.

As will be clear from Fig. 2, the channel width of each cell transistor is determined by the field oxide layer FL, which is created at an early stage of the ROM fabrication process. This gives rise to the disadvantage of long delivery time as previously described.

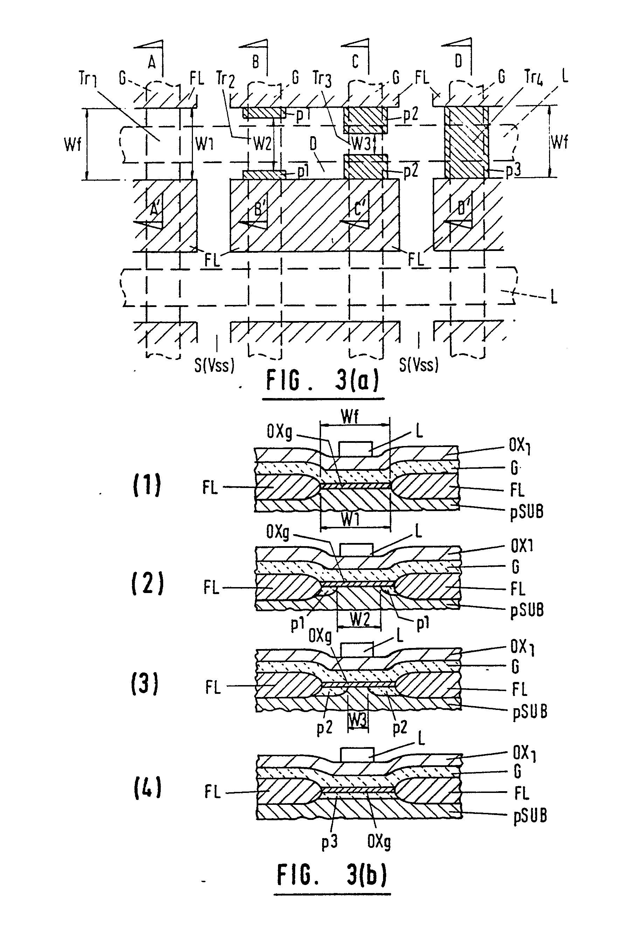

In Fig. 3, which illustrates an embodiment of the present invention, (a) is a plan view of the memory matrix of a NOR type multi-level mask ROM seen through electrode wiring (indicated by broken lines) and the gate oxide layer, and (b) shows at (1), (2), (3), (4) structures of four types of cell transistor ($Tr_1$, $Tr_2$, $Tr_3$ and $Tr_4$) in sections taken respectively along the flagged lines A—A', B—B', C—C' and D—D' in (a).

In Fig. 3, P-SUB is a p-type silicon substrate, having a dopant density of approximately $5 \times 10^{15}$ (atm/cm³), FL is a field oxide layer; that is, a thick oxide layer for restricting the areas of the cell transistors. OXg is a gate oxide layer (500 to 1000 Å thick); that is, a thin oxide layer. G indicates $n^+$-type polycrystalline silicon gate electrodes, S is an $n^+$ type source region containing a Vss line, D is an $n^+$ type drain region, $OX_1$ is an insulating layer, L is aluminium (Al) drain wiring, $P_1$, $P_2$ and $P_3$ are heavily p doped regions whose surface (doping) density is approximately $10^{17}$ (atm/cm³), Wf is the channel width defined by field oxide layers (4 µm for instance), $W_1$ is the maximum possible channel width, determined by the field oxide layer FL (4 µm for instance), $W_2$ is an effective channel width determined by highly doped regions $P_1$ (3 µm for instance), and $W_3$ is an effective channel width determined by highly doped regions $P_2$ (2 µm for instance).

The mask ROM having structure of Fig. 3 has four output levels. The first output level is provided by the cell transistor $Tr_1$ having the widest channel width $W_1$ (4 µm), which is determined by the field oxide layer FL. The second output level is provided by the cell transistor $Tr_2$ having the second widest effective channel width $W_2$ (3 µm), which is determined by two heavily p-type doped regions $P_1$. The third output level is provided by the cell transistor $Tr_3$, whose channel has a narrow width $W_3$ (2 µm) determined by the two heavily p-type doped regions $P_2$. The fourth output level is provided by the cell transistor $Tr_4$ where the channel is masked completely by the heavily p-type doped layer $P_3$.

Now, a method of fabricating an MOS ROM in accordance with an embodiment of the present invention will be described with reference to Figs. 4 to 9. Each of those Figures, corresponding to a particular stage in the fabrication of the ROM, has a plan view, a sectional view (4) taken along a flagged line D—D', in the plan view, which is perpendicular to gate electrode lines of the MOS ROM, and sectional views ((1), (2), (3)), taken along flagged lines A—A', B—B' and C—C' in the plan view, of three types of cell transistors ($Tr_1$, $Tr_2$, $Tr_3$) formed in the device.

A p-type silicon substrate 1 having a dopant density of 1 to $2 \times 10^{16}$ (atm/cm³), for instance, is prepared. The fabrication begins with the formation of a field oxide (silicon dioxide) layer 3 using a conventional LOCOS (Local Oxidation of Silicon) method. As shown in Fig. 4 the field oxide layer 3 is formed on the substrate 1 selectively, by a conventional thermal oxidizing method with a masking pattern of silicon nitride ($Si_3N_4$) film formed by conventional photo-lithographic technology. After removal of any remaining masking material by etching, the areas for the formation of cell transistors and other circuitry elements are ready.

Usually a channel cut layer is formed underneath the field oxide layer 3, but this is not a direct concern of the present invention and so mention thereof will be omitted from the description and the Figures.

As can be seen in sectional views (1), (2) and (3) in Fig. 4, about half of the thickness of the field oxide layer 3 grows up above the original top surface of the substrate 1.

After the field oxide layer 3 has been grown, another silicon oxide layer of 500 to 1000 Å thickness is formed by a conventional thermal oxidation method on the substrate to form gate oxide layer 4 as shown in Fig. 5. This step is followed by the formation of a polycrystalline silicon layer of 4000 to 5000 Å thickness using a conventional chemical vapor deposition (CVD) method, and the layer is doped heavily with n-type dopant (phosphorus for instance) by a conventional gas diffusion method or ion implantation method.

Next, as shown in Fig. 5, the $n^+$ type polycrystalline silicon is etched to form the silicon gate electrodes 5. A conventional photo-lithographic technology utilizing reactive-ion etching method can be used for this pattern formation. A gas mixture of tetra-fluoro-methane ($CF_4$) and oxygen ($O_2$) is suitable for the above etching.

Utilizing the $n^+$-type doped polycrystalline silicon gate electrodes 5 and the field oxide layer 3 as a mask, $n^+$-type source region 7 (containing Vss lines) and $n^+$-type drain region 8 are created by a conventional ion implantation method as shown in Fig. 6. The dopant material is arsenic (As), and is implanted with an acceleration energy of about 80 KeV at a high dose of around $4 \times 10^{15}$ (atm/cm$^2$) for instance. The implanted dopant, penetrating through the exposed gate silicon oxide layer 4, reaches the silicon substrate 1 and is diffused into it by a predetermined annealing treatment to provide $n^+$-type regions of 3000 to 4000 Å depth. These are the source regions 7 (including Vss lines) and drain regions 8 of the cell transistors respectively.

Now the device is ready for the setting therein of the multi-level information required to be stored.

Devices at this stage of production can be stocked by a manufacturer to await an order from a customer specifying the information to be stored. Thus, it is possible to supply the customers with multi-level ROMs quickly as compared with the situation which prevailed previously, when the manufacturer could stock only devices at the stage of Fig. 4.

The surface of the device at the "half-fabricated" stage of Fig. 6 is covered with a conventional photo-resist film 9, and then, corresponding to the specified information to be stored, windows $a_1$, $a_2$ and b are opened for the cell transistors $Tr_1$, $Tr_2$ and $Tr_4$, for instance, as shown in Fig. 7(a). These windows are formed by a conventional photo-lithographic technology on the areas where $p^+$-type doped regions are to be created in correspondence to the information level to be stored.

Then, p-type dopant, boron (B) for instance, is implanted at the dose of 4 to $5 \times 10^{13}$ (atm/cm$^2$), with a high acceleration energy, 160 (KeV) for instance, through the windows $a_1$, $a_2$, b, etc. The photo-resist pattern 9 acts as a mask. For the dopant ions, the above-mentioned acceleration energy is high enough for the ions to penetrate the polycrystalline silicon layer 5 and gate silicon layer 4 and form boron$^+$ implanted regions $11a_1$, $11a_2$ and 11b in channel areas as shown in Fig. 7.

After removing the photo-resist layer 9, the device is annealed to diffuse the implanted dopant (boron) to form the $p^+$-type regions 12a, 12b, 12c etc. of 3000 Å thickness at channel areas underneath the gate silicon oxide layer 4 as shown in Fig. 8. The dopant diffuses not only in the thickness direction but also in lateral (sideways) directions and reduces the distance between the original implanted regions (e.g. $11a_1$, $11a_2 \rightarrow 12a$, 12b). Thus, the distance $d_a$ between

implanted regions (e.g. the distance between the windows $a_1$ and $a_2$ shown in Fig. 7) should be determined to take account in advance of lateral diffusion of dopant.

In the particular case shown in the Figures, for the cell transistor $Tr_2$ for example, the window distance is taken to be 3.6 μm and the distance between two $p^+$-doped regions turns out to be 3.0 μm.

Two $p^+$-doped regions are created at opposite sides of the channel. If only one $p^+$-type doped region were created, at one side of the channel, difficulty could be experienced in obtaining precise dimensional control of channel width because that width depends significantly on mask alignment. By creating two $p^+$ regions, the width of an effective channel region $d_a$ is determined by the window openings $a_1$ and $a_2$ (Fig. 7) in the mask, and mask alignment is not critical.

In Fig. 8, three types of cell transistors at this stage of the fabrication process are shown. A cell transistor $Tr_1$, which has no p-type regions in its channel area, has the original channel width Wf or $W_1$ (Wtr in Fig. 4), the widest possible channel width, determined by the field oxide layer 3. Thus, the cell transistor $Tr_1$ provides the highest gate current and provides the ROM with a first output level. The cell transistor $Tr_2$, which has two p-type doped regions 12a and 12b, has a narrower effective channel width $W_2$ and provides a second output level. The cell transistor $Tr_4$, whose channel area is occupied fully by p-typed doped region 12c, is regarded as being in an OFF stage and provides a fourth output level. A transistor $Tr_3$ (not shown) with a channel width less than $W_2$ can provide a third output level. In a similar way, it is possible to set more levels for an output signal in accordance with information to be stored.

Next, another thin silicon dioxide layer 13 is formed over the device by a conventional thermal oxidizing method, and an insulating layer 14 of phosphosilicate glass (PSG) is formed on the silicon dioxide layer 13. This is followed by etching of electrode contact windows such as drain contact window 15 (other windows are not shown in the Figures) using a conventional photolithography method. The edges of contact windows are rounded by heating the device to reflow the PSG layer. Electrode wirings 16 of aluminium or other materials are formed on the PSG layer 14 by conventional photo-lithographic technology and film forming technology as shown in Fig. 9.

Finally, though it is not shown further in the Figures, circuitry protecting means are formed on the substrate and the multi-level mask ROM is completed.

As described above, the present invention can afford the advantage of reduced fabrication time for semiconductor multi-level memory devices to allow quick delivery in response to customers' orders.

A manufacturer can stock the slices of semiconductor multi-level ROMs at the "half-fabricated" stage, ready for writing-in of information to be stored. When requested by a customer, the fabrication of multi-level ROMs for the customer effectively starts with the writing process for the ROM. This cuts down fabrication time and shortens the delivery time. For example, the delivery time of a multi-level ROM can be reduced from the current time of 8 weeks to a time of 3 weeks by the application of the present invention.

It will be clear that embodiments of the present invention can provide memories offering any chosen number of output signal levels, by providing for an appropriate number of different channel widths in the memory.

Although the described embodiments of the invention are n-channel (i.e. use n-channel transistors), it will be clear that p channel memories can be provided.

In addition, it will be clear that conventional semiconductor fabricating methods are applicable to each fabrication step required for a device according to the present invention.

An embodiment of this invention provides a multi-level semiconductor read only memory. Effective channel widths of the gates of MIS transistors of the memory are varied corresponding to the levels of information to be stored in the transistors. Variation of the effective channel width is performed by forming doped regions of an original channel region. The time required to fabricate a multi-level ROM can be reduced to less than a half that previously required.

## Claims

1. A semiconductor memory device, having a plurality of multi-level memory cells with metal insulator semiconductor transistors (Tr$_1$ to Tr$_4$) formed in zones defined by field insulation (FL, 3), each comprising source (S, 7) and drain (D, 8) regions doped with a first conductivity type, and a channel region doped with a second conductivity type, and each having the same maximum possible channel width (Wf, W1, Wtr) defined by the field insulation (FL, 3), at least one of the said transistors (e.g. Tr$_2$) also having two additional doped regions (P1, P2, 12a, 12b), provided respectively on opposite sides of the channel of the transistor concerned, doped with dopant of the second conductivity type, to a higher concentration than the rest of that channel, giving the transistor concerned an effective channel width (e.g. W2) less than the maximum possible channel width (Wf, Wtr) therefor.

2. A device as claimed in claim 1, the said transistors each further comprising a gate oxide layer (OXg, 4) and a gate electrode (G, 5) for example of doped polycrystalline silicon.

3. A device as claimed in claim 1 or 2, there being, among the said transistors, transistors (Tr$_2$, Tr$_3$) having such additional doped regions (P1, P2) giving them respective different effective channel widths each less than the maximum possible channel width.

4. A device as claimed in claim 1, 2 or 3, there being, among the said transistors, at least one transistor (Tr$_4$) having a further doped region (P3, 12C) extending across the whole channel width (W1, Wf) as defined by the field insulation (FL, 3), giving that transistor an effective channel width of zero.

5. A device as claimed in any preceding claim, wherein the field insulation (FL, 3) is provided by field oxide, and each of the said transistors has an effective channel width (which may be the maximum possible channel width therefor as defined by the field insulation, or a lesser width) selected in accordance with information to be stored in the memory cell to which it belongs.

6. A device as claimed in any preceding claim, wherein the said transistors are all of one channel type, either p-channel type or n-channel type, each such additional or further doped region (P1, P2, P3, 12a, 12b, 12c) being doped to a dopant density greater than $10^{17}$ atm/cm$^3$ with a dopant opposite to the channel type.

7. A method of fabricating a semiconductor memory device from a "half-fabricated" semiconductor memory device, the latter being a device as claimed in claim 1 or 2 taken to a stage in its production immediately prior to formation of such additional doped regions (P1, P2, P3, 12a, 12b, 12c), the method comprising selectively implanting the said dopant, through gate electrodes (G, 5) and gate oxide layers (OXg, 4) if necessary, to provide at least one of the said transistors (e.g. Tr$_2$) with the said two additional doped regions (P1, P2, 12a, 12b), respectively on opposite sides of the channel of the transistor concerned, giving the transistor concerned an effective channel width (e.g. W2) less than the maximum possible channel width (Wf, Wtr) therefor, in accordance with information to be stored in the memory cell to which it belongs.

## Patentansprüche

1. Halbleiterspeichervorrichtung, mit einer Vielzahl von Multipegel-Speicherzellen mit Metall-Isolator-Halbleitertransistoren (Tr$_1$ bis Tr$_4$), die in Zonen gebildet sind, die durch Feldisolation (FL, 3) begrenzt sind, die jeweils Source- (S, 7) und Drain-(D, 8)-bereiche umfassen, die mit einem ersten Leitfähigkeitstyp dotiert sind, und einen Kanalbereich, der mit einem zweiten Leitfähigkeitstyp dotiert ist, und die jeweils dieselbe maximal mögliche Kanalbreite (Wf, W1, Wtr) haben, die durch die Feldisolation (FL, 3) begrenzt ist, wobei wenigstens einer der genannten Transistoren (z.B. Tr$_2$) auch zwei zusätzlich dotierte Bereiche (P1, P2, 12a, 12b) hat, die jeweils auf entgegengesetzten Seiten des Kanals des betreffenden Transistors vorgesehen sind, dotiert mit einem Dotierungsmittel von einem zweiten Leitfähigkeitstyp auf eine Konzentration höher als der Rest von jenem Kanal, wodurch dem betreffenden Transistor eine effektive Kanalbreite (z.B. W2) kleiner als die maximal mögliche Kanalbreite (Wf, Wtr) dafür gegeben ist.

2. Vorrichtung nach Anspruch 1, bei welcher jeder genannte Transistor ferner eine Gate-Oxidschicht (OXg, 4) und eine Gate-Elektrode (G, 5) z.B. aus dotiertem polykristallinen Silizium umfaßt.

3. Vorrichtung nach Anspruch 1 oder 2, bei der es, zwischen den genannten Transistoren, Transistoren (Tr₂, Tr₃) gibt, welche solch zusätzlich dotierte Bereiche (P1, P2) haben, die ihnen jeweils verschiedene effektive Kanalbreiten geben, jede kleiner als die maximal mögliche Kanalbreite.

4. Vorrichtung nach Anspruch 1, 2 oder 3, bei der es, unter den genannten Transistoren, wenigstens einen Transistor (Tr₄) gibt, der einen weiteren dotierten Bereich (P3, 12C) hat, der sich quer über die ganze Kanalbreite (W1, Wf), die durch die Feldisolation (FL, 3) begrenzt ist, erstreckt, welche jenem Transistor eine effektive Kanalbreite von 0 gibt.

5. Vorrichtung nach einem der vorhergehenden Ansprüche, bei der die Feldisolation (FL, 3) durch Feldoxid gebildet ist, und jeder der genannten Transistoren eine effektive Kanalbreite (welche die maximal dafür mögliche Kanalbreite sein kann, wie sie durch die Feldisolation begrenzt ist, oder eine kleinere Breite) hat, die in Übereinstimmung mit Information ausgewählt ist, die in die Speicherzelle gespeichert werden soll, zu welcher sie gehört.

6. Vorrichtung nach einem der vorhergehenden Ansprüche, bei der die genannten Transistoren alle von einem Kanaltyp sind, entweder p-Kanaltyp oder n-Kanaltyp, und jeder solche zusätzliche oder weitere dotierte Bereich (P1, P2, P3, 12a, 12b, 12c) auf eine Dotierungsdichte dotiert ist, die größer als $10^{17}$ atm/cm³ ist, mit einem Dotierungsmittel entgegengesetzt zu dem Kanaltyp.

7. Verfahren zur Herstellung einer Halbleiterspeichervorrichtung aus einer "halbfabrizierten" Halbleiterspeichervorrichtung, welch letztere eine Vorrichtung nach Anspruch 1 oder 2 ist, die in ihrer Produktionsstufe unmittelbar vor der Bildung von solch zusätzlich dotierten Bereichen (P1, P2, P3, 12a, 12b, 12c) genommen wird, welches Verfahren das selektive Implantieren des genannten Dotierungsmittels durch Gate-Elektroden (G, 5) und Gate-Oxidschichten (OXg, 4), falls notwendig, umfaßt, um wenigstens einen der genannten Transistoren (z.B. Tr₂) mit den genannten beiden zusätzlich dotierten Bereichen (P1, P2, 12a, 12b) zu bilden, jeweils auf gegenüberliegenden Seiten des Kanals des betreffenden Transistors, wodurch dem betreffenden Transistor eine effektive Kanalbreite (z.B. W2) gegeben wird, die kleiner als die maximal mögliche Kanalbreite (Wf, Wtr) dafür ist, in Übereinstimmung mit Information, die in die Speicherzelle einzuspeichern ist, zu welcher sie gehört.

## Revendications

1. Dispositif de mémoire à semiconducteur, comportant un ensemble de cellules de mémoire à plusieurs niveaux qui comprennent des transistors à métal-isolant-semiconducteur (Tr₁ à Tr₄) formés dans des zones définies par un isolement de champ (FL, 3), chacun comprenant des régions de source (S, 7) et de drian (D, 8) dopées ayant un premier type de conductivité, et une région de canal dopée ayant un second type de conductivité, et ayant chacun la même largeur de canal possible maximale (Wf, W1, Wtr) définie par l'isolement de champ (FL, 3), au moins un des transistors (par exemple Tr₂) comportant également deux régions dopées (P1, P2, 12a, 12b) supplémentaires, prévues respectivement des côtés opposés du canal du transistor concerné, dopées avec un élément dopant du second type de conductivité, à une concentration supérieure à celle du reste de ce canal, ce qui donne au transistor concerné une largeur de canal effective (par exemple W2) inférieure à la largeur de canal possible maximale (Wf, Wtr) de celui-ci.

2. Dispositif selon la revendication 1, dans lequel les transistors comprennent en outre chacun une couche d'oxyde de grille (OXg, 4) et une électrode de grille (G, 5), par exemple de silicium polycristallin dopé.

3. Dispositif selon l'une quelconque des revendications 1 et 2, dans lequel il y a, parmi les transistors, des transistors (Tr₂, Tr₃) comportant les régions dopées (P1, P2) supplémentaires leur donnant des largeurs de canaux effectives différentes respectives, inférieures chacune à la largeur de canal possible maximale.

4. Dispositif selon l'une quelconque des revendications 1 à 3, dans lequel il y a, parmi les transistors, au moins un transistor (Tr₄) comportant une autre région dopée (P3, 12c) s'étendant sur toute la largeur de canal (W1, Wf) telle que définie par l'isolement de champ (FL, 3), ce qui donne à ce transistor une largeur de canal effective nulle.

5. Dispositif selon l'une quelconque des revendications 1 à 4, dans lequel l'isolement de champ (FL, 3) est fourni par un oxyde de champ, et dans lequel chacun des transistors a une largeur de canal effective (qui peut être la largeur de canal possible maximale pour celui-ci telle que définie par l'isolement de champ, ou une largeur inférieure) sélectionnée selon l'information à mémoriser dans la cellule de mémoire à laquelle il appartient.

6. Dispositif selon l'une quelconque des revendications 1 à 5, dans lequel les transistors sont tous d'un type de canal, soit de type de canal p, soit de type de canal n, chaque région dopée supplémentaire ou autre région dopée (P1, P2, P3, 12a, 12b, 12c) étant dopée à une densité d'élément dopant supérieure à $10^{17}$ atomes/cm³ avec un élément dopant opposé au type de canal.

7. Procédé de fabrication d'un dispositif de mémoire à semiconducteur à partir d'un dispositif de mémoire à semiconducteur "à demi-fabriqué", ce dernier étant un dispositif selon l'une quelconque des revendications 1 et 2 pris à un stade de sa fabrication juste avant la formation des régions dopées supplémentaires (P1, P2, P3, 12a, 12b, 12c), le procédé consistant à implanter sélectivement l'élément dopant, par les électrodes de grille (G, 5) et les couches d'oxyde de grille (OXg, 4) si nécessaire, pour obtenir au moins un des transistors (par exemple Tr$_2$) avec les deux régions dopées supplémentaires (P1, P2, 12a, 12b), respectivement des côtés opposés du canal du transistor concerné, ce qui donne au transistor concerné une largeur de canal effective (par exemple, W2) inférieure à la largeur de canal possible maximale (Wf, Wtr) de celui-ci, selon l'information à mémoriser dans la cellule de mémoire à laquelle il appartient.

8

WL

BL

## FIG. 1(a)

WL

BL

## FIG. 1(b)

1

## FIG. 2(a)

## FIG. 2(b)

FIG. 3(a)

FIG. 3(b)

3

## FIG. 4(a)

## FIG. 4(b)

(1)
Section A - A'

(2)
Section B - B'

(3)
Section C - C'

(4)
Section D - D'

## FIG. 5(a)

## FIG. 5(b)

(1)
Section A - A'

(2)
Section B - B'

(3)
Section C - C'

(4)

Section D - D'

# FIG. 6(a)

B  5  A     Vss   B      5     8      C      5

D                                                    D'

3

7                    7                              3

A'              7        B'           C'

# FIG. 6(b)

(1)
## Section A - A'

(2)
## Section B - B'

(3)
## Section C - C'

(4)
## Section D - D'

# FIG. 7(a)

A  5        5  B    a₁        9      C  5      b

D                                              D'

da

A'           B'       a₂         C'

# FIG. 7(b)

(1)

Section A - A'

(2)

Section B - B'

(3)

Section C - C'

(4)

Section D - D'

## FIG. 8(a)

## FIG. 8(b)

(1)
### Section A - A'

(2)
### Section B - B'

(3)
### Section C - C'

(4)
### Section D - D'

**0 119 729**

## FIG. 9(a)

## FIG. 9(b)

(1)
**Section A - A'**

(2)
**Section B - B'**

(3)
**Section C - C'**

(4)
**Section D - D'**

9